# EUROPÄISCHE PATENTSCHRIFT

(11) **EP 4 318 948 B1**
(45) Veröffentlichungstag und Bekanntmachung des Hinweises auf die Patenterteilung: **01.04.2026**
(21) Anmeldenummer: 23182247.9
(22) Anmeldetag: 29.06.2023
(51) Int. Cl.: H03K 17/082, H03K 17/12

(54) **TRENNSCHALTERANORDNUNG FÜR EIN BORDSPANNUNGSNETZ EINES FAHRZEUGS**
DISCONNECTOR ASSEMBLY FOR AN ON-BOARD VOLTAGE NETWORK OF A VEHICLE
ENSEMBLE SECTIONNEUR POUR UN RÉSEAU DE TRACTION EMBARQUÉ D'UN VÉHICULE

(30) Priorität: 03.08.2022 DE 102022119431
(43) Veröffentlichungstag der Anmeldung: 07.02.2024
(73) Patentinhaber: Eberspächer Controls Landau GmbH & Co. KG, 76829 Landau (DE); Eberspächer Controls Esslingen GmbH & Co. KG, 73730 Esslingen (DE)
(72) Erfinder: Wandres, Steffen, Kandel (DE); Kriessl, Michael, Göppingen (DE)
(74) Vertreter: Ruttensperger Lachnit Trossin Gomoll

(56) Entgegenhaltungen:
- DE-B3- 102019 128 849
- US-A1- 2022 014 184

## Beschreibung

Die vorliegende Erfindung betrifft ein Bordspannungsnetz für ein Fahrzeug mit einer Trennschalteranordnung zum wahlweisen Verbinden einer Spannungsquelle mit einer Last und Trennen der Spannungsquelle von der Last.

Um in einem Bordspannungsnetz eines Fahrzeugs das Auftreten von Überströmen oder Kurzschlüssen erfassen zu können, ist es beispielsweise bekannt, einem derartigen Bordspannungsnetz eine Strommessbaugruppe zuzuordnen, wie diese aus der DE 10 2019 108 541 A1 bekannt ist. Bei dieser Strommessbaugruppe ist zwischen zwei Stromschienen ein Shunt-Widerstand geschaltet. Um den über den Shunt-Widerstand fließenden elektrischen Strom zu erfassen, sind diesem zwei Messleiterbahnen zugeordnet, über welche der Spannungsabfall am Shunt-Widerstand und somit auch der über diesen fließende elektrische Strom erfasst werden kann. Bei hohen Lastströmen werden an einem derartigen niederohmigen Shunt-Widerstand vergleichsweise hohe Verlustleistungen frei, während bei kleinen Strömen die entsprechend niedrigen Messwerte in einem auch zu einem zusätzlichen Energieverbrauch führenden Operationsverstärker auf einen auswertbaren Signalpegel verstärkt werden müssen.

Aus der DE 10 2019 128 849 B3 ist eine Trennschalteranordnung bekannt, bei welcher ein zur Stromerfassung ausgebildeter Leistungstransistor zu einer Mehrzahl von externen Transistoren parallel geschaltet ist. Bei in ihren Leitungszustand geschalteter Trennschalteranordnung wird der über den Leistungstransistor fließende elektrische Strom erfasst und auf der Grundlage dieses elektrischen Stroms der gesamte über die Trennschalteranordnung fließende Strom ermittelt.

Die US 2022/0014184 A1 offenbart eine Trennschalteranordnung mit einer Mehrzahl von zueinander parallel geschalteten und zusammen zwischen einem leitenden Zustand und einem Trennzustand umschaltbaren MOSFET-Schaltvorrichtungen. Bei einer der MOSFET-Schaltvorrichtungen wird der über diese fließende elektrische Strom erfasst.

Es ist die Aufgabe der vorliegenden Erfindung, ein Bordspannungsnetz für ein Fahrzeug mit einer Trennschalteranordnung bereitzustellen, mit welcher in einfacher und zuverlässiger Art und Weise und im Wesentlichen ohne zusätzlichen Energieverbrauch Information über den in einem Bordspannungsnetz fließenden elektrischen Strom bereitgestellt werden kann.

Erfindungsgemäß wird diese Aufgabe gelöst durch ein Bordspannungsnetz für ein Fahrzeug gemäß Anspruch 1, umfassend eine Spannungsquelle und eine von der Spannungsquelle mit elektrischer Energie zu speisende Last. Das Bordspannungsnetz umfasst eine Trennschalteranordnung, wobei ein Spannungsquelle-Anschlussbereich der Trennschalteranordnung mit der Spannungsquelle verbunden ist und ein Last-Anschlussbereich mit der Last verbunden ist.

Die Trennschalteranordnung umfasst neben dem Spannungsquelle-Anschlussbereich und dem Last-Anschlussbereich eine Mehrzahl von zwischen dem Spannungsquelle-Anschlussbereich und dem Last-Anschlussbereich zueinander parallel geschalteten MOSFET-Trennschalterelementen, wobei wenigstens ein MOSFET-Trennschalterelement der Mehrzahl von MOSFET-Trennschalterelementen als Stromüberwachung-Trennschalterelement zum Bereitstellen einer einen zwischen dem Spannungsquelle-Anschlussbereich und dem Last-Anschlussbereich fließenden elektrischen Strom repräsentierenden Stromgröße ausgebildet ist und wenigstens ein MOSFET-Trennschalterelement der Mehrzahl von MOSFET-Trennschalterelementen nicht als Stromüberwachung-Trennschalterelement ausgebildet ist.

Bei dem erfindungsgemäß aufgebauten Bordspannungsnetz nutzt die Trennschalteranordnung verschiedene Arten von MOSFET-Trennschalterelementen. Die nicht als Stromüberwachung-Trennschalterelemente ausgebildeten MOSFET-Trennschalterelemente stellen im Wesentlichen Lastschalter bereit, über welche im Betrieb eines Fahrzeugs, also bei mit der Spannungsquelle verbundener Last, ein wesentlicher Teil des elektrischen Stroms fließt. Das wenigstens eine als Stromüberwachung-Trennschalterelement ausgebildete und allgemeinen als IPS (Intelligent Power Switch) bezeichnete MOSFET-Trennschalterelement leitet im Betrieb gleichermaßen einen Teil des zwischen der Spannungsquelle und der Last fließenden elektrischen Stroms, jedoch nur einen deutlich geringeren Teil, als das bzw. die nicht als Stromüberwachung-Trennschalterelemente ausgebildeten und als Lastschalter wirkenden MOSFET-Trennschalterelemente. Dieser Teil des gesamten Stroms ist ausreichend groß, um eine genaue Erfassung des über das wenigstens eine als Stromüberwachung-Trennschalterelement ausgebildete MOSFET-Trennschalterelement fließenden Stroms gewährleisten zu können, ist andererseits jedoch auch ausreichend klein, um zu gewährleisten, dass auch bei hoher Belastung der zulässige Kurzschlussstrom eines derartigen als Stromüberwachung-Trennschalterelement ausgebildeten MOSFET-Trennschalterelements grundsätzlich nicht überschritten wird.

Um bei einfach strukturiertem, kostengünstigem Aufbau die benötigte Information über die Höhe des Stroms bereitstellen zu können, wird vorgeschlagen, dass ein einziges MOSFET-Trennschalterelement als Stromüberwachung-Trennschalterelement ausgebildet ist, oder/und dass eine Mehrzahl der MOSFET-Trennschalterelemente nicht als Stromüberwachung-Trennschalterelement ausgebildet ist.

Bei der Trennschalteranordnung weist jedes MOSFET-Trennschalterelement einen mit dem Spannungsquelle-Anschlussbereich verbundenen Spannungsquelle-Anschluss, vorzugsweise Drain-Anschluss, einen mit dem Last-Anschlussbereich verbundenen Last-Anschluss, vorzugsweise Source-Anschluss, und einen mit einer Ansteuereinheit verbundenen Gate-Anschluss auf.

Um in der Trennschalteranordnung Leistungsverluste möglichst gering zu halten, , weist das wenigstens eine als Stromüberwachung-Trennschalterelement ausgebildete MOSFET-Trennschalterelement in seinem die Spannungsquelle mit der Last verbindenden leitenden Zustand einen Stromüberwachung-Trennschalterelement-Widerstand zwischen seinem Spannungsquelle-Anschluss und seinem Last-Anschluss auf und weist das wenigstens eine nicht als Stromüberwachung-Trennschalterelement ausgebildete MOSFET-Trennschalterelement in seinem die Spannungsquelle mit der Last verbindenden leitenden Zustand einen MOSFET-Trennschalterelement-Widerstand zwischen seinem Spannungsquelle-Anschluss und seinem Last-Anschluss auf. Der Stromüberwachung-Trennschalterelement-Widerstand ist größer als der MOSFET-Trennschalterelement-Widerstand.

Insbesondere kann dabei eine einen für eine präzise Erfassung ausreichend hohen Stromfluss über das wenigstens eine Stromüberwachung-Trennschalterelement vorsehende Ausgestaltung erreicht werden, wenn ein Verhältnis des durch alle nicht als Stromüberwachung-Trennschalterelement ausgebildeten MOSFET-Trennschalterelemente bereitgestellten Gesamt-MOSFET-Trennschalterelement-Widerstands zu dem durch alle als Stromüberwachung-Trennschalterelemente ausgebildeten MOSFET-Trennschalterelemente bereitgestellten Gesamt-Stromüberwachung-Trennschalterelement-Widerstand im Bereich von 0,05-0,15 liegt.

Um das wenigstens eine als Stromüberwachung-Trennschalterelement ausgebildete MOSFET-Trennschalterelement vor einem zu hohen Strom zu schützen, kann dieses eine Überstrom-Schutzschaltung enthalten, wobei die Überstrom-Schutzschaltung dazu ausgebildet ist, bei über einem Schwellenstrom liegendem elektrischen Strom zwischen dem Spannungsquelle-Anschluss und dem Last-Anschluss des wenigstens einen als Stromüberwachung-Trennschalterelement ausgebildeten MOSFET-Trennschalterelements das wenigstens eine als Stromüberwachung-Trennschalterelement ausgebildete MOSFET-Trennschalterelement in einen Zustand zum Trennen der Spannungsquelle von der Last zu schalten oder in diesem zu halten.

Um weiterhin das wenigstens eine als Stromüberwachung-Trennschalterelement ausgebildete MOSFET-Trennschalterelement vor Überhitzung zu schützen, kann dieses eine Übertemperatur-Schutzschaltung enthalten, wobei die Übertemperatur-Schutzschaltung dazu ausgebildet ist, bei über einer Schwellentemperatur liegender Temperatur des wenigstens einen als Stromüberwachung-Trennschalterelement ausgebildeten MOSFET-Trennschalterelements das wenigstens eine als Stromüberwachung-Trennschalterelement ausgebildete MOSFET-Trennschalterelement in einen Zustand zum Trennen der Spannungsquelle von der Last zu schalten oder in diesem zu halten.

Um den zwischen der Spannungsquelle und der Last fließenden elektrischen Strom wahlweise über das wenigstens eine Stromüberwachung-Trennschalterelement leiten zu können, ist das wenigstens eine als Stromüberwachung-Trennschalterelement ausgebildete MOSFET-Trennschalterelement unabhängig von wenigstens einem, vorzugsweise jedem nicht als Stromüberwachung-Trennschalterelement ausgebildeten MOSFET-Trennschalterelement in einen Zustand zum Verbinden der Spannungsquelle mit der Last und einen Zustand zum Trennen der Spannungsquelle von der Last schaltbar.

Für einen schaltungstechnisch einfach zu realisierenden Aufbau ist vorgesehen, dass alle nicht als Stromüberwachung-Trennschalterelemente ausgebildeten MOSFET-Trennschalterelemente gemeinsam in einen Zustand zum Verbinden der Spannungsquelle mit der Last und einen Zustand zum Trennen der Spannungsquelle von der Last schaltbar sind. Eine voneinander unabhängige Ansteuerung dieser MOSFET-Trennschalterelemente ist daher nicht erforderlich.

Um für eine präzise Erfassung des zwischen der Spannungsquelle und der Last fließenden elektrischen Stroms das Auftreten von Temperaturunterschieden zwischen den verschiedenen MOSFET-Trennschalterelementen zu vermeiden, wird vorgeschlagen, dass der Spannungsquelle-Anschlussbereich eine mit allen MOSFET-Trennschalterelementen elektrisch und thermisch leitend verbundene Stromschiene, vorzugsweise Kupferschiene, umfasst, oder/und dass der Last-Anschlussbereich eine mit allen MOSFET-Trennschalterelementen elektrisch und thermisch leitend verbundene Stromschiene, vorzugsweise Kupferschiene, umfasst. Ferner betrifft die Erfindung ein Verfahren zum Betreiben eines erfindungsgemäß aufgebauten Bordspannungsnetzes, bei welchem Verfahren in einem Niederlast-Betriebszustand des Bordspannungsnetzes wenigstens ein als Stromüberwachung-Trennschalterelement ausgebildetes MOSFET-Trennschalterelement in einen Zustand zum Verbinden der Spannungsquelle mit der Last geschaltet ist und wenigstens ein nicht als Stromüberwachung-Trennschalterelement ausgebildetes MOSFET-Trennschalterelement in einen Zustand zum Trennen der Spannungsquelle von der Last geschaltet ist. Ein derartiger Niederlast-Betriebszustand kann beispielsweise ein Parkzustand eines Fahrzeugs sein, in welchem die Last im Wesentlichen durch Verbraucher wie zum Beispiel eine Alarmanlage oder sonstige Sicherheitssysteme bereitgestellt ist, die das Bordspannungsnetz nur gering belasten und daher auch nur zu einem das wenigstens eine als Stromüberwachung-Trennschalterelement ausgebildete MOSFET-Trennschalterelement nicht überlastenden Stromfluss führen. Da in diesem Zustand der gesamte Strom über das wenigstens eine als Stromüberwachung-Trennschalterelement ausgebildete MOSFET-Trennschalterelement fließt, kann eine vergleichsweise hohe Erfassungsgenauigkeit des Stromflusses über dieses erreicht werden.

Vorzugsweise ist bei dem erfindungsgemäßen Verfahren vorgesehen, dass in dem Niederlast-Betriebszustand jedes als Stromüberwachung-Trennschalterelement ausgebildete MOSFET-Trennschalterelement in den Zustand zum Verbinden der Spannungsquelle mit der Last geschaltet ist oder/und jedes nicht als Stromüberwachung-Trennschalterelement ausgebildete MOSFET-Trennschalterelement in den Zustand zum Trennen der Spannungsquelle von der Last geschaltet ist.

Um beim Auftreten höherer Belastungen, beispielsweise durch das Zuschalten einer Standheizung oder anderer Verbraucher elektrischer Energie, eine Überlastung des wenigstens einen als Stromüberwachung-Trennschalterelement ausgebildeten MOSFET-Trennschalterelements zu vermeiden, wird vorgeschlagen, dass dann, wenn in dem Niederlast-Betriebszustand alle nicht als Stromüberwachung-Trennschalterelemente ausgebildeten MOSFET-Trennschalterelemente in den Zustand zum Trennen der Spannungsquelle von der Last geschaltet sind, wenigstens ein Teil der, vorzugsweise alle nicht als Stromüberwachung-Trennschalterelemente ausgebildeten MOSFET-Trennschalterelemente in den Zustand zum Verbinden der Spannungsquelle mit der Last geschaltet werden, wenn die durch das wenigstens eine als Stromüberwachung-Trennschalterelement ausgebildete MOSFET-Trennschalterelement bereitgestellte Stromgröße einen über einem Schwellenstrom liegenden elektrischen Strom indiziert oder/und eine über einem Schwellenstromgradienten liegende zeitliche Änderung des elektrischen Stroms indiziert.

Um in jedem Betriebszustand eines Bordspannungsnetzes eines Fahrzeugs, in welchem eine Last aus der Spannungsquelle zu speisen ist, das Vorliegen von Information über den zwischen der Spannungsquelle und der Last fließenden elektrischen Strom gewährleisten zu können, wird weiter vorgeschlagen, dass dann, wenn die Spannungsquelle vermittels der Trennschalteranordnung mit der Last zu verbinden ist, wenigstens das wenigstens eine als Stromüberwachung-Trennschalterelement ausgebildete MOSFET-Trennschalterelement in einen Zustand zum Verbinden der Spannungsquelle mit der Last geschaltet wird.

Die vorliegende Erfindung wird nachfolgend mit Bezug auf die beiliegende Figur detailliert beschrieben, welche eine Schaltskizze einer Trennschalteranordnung in einem Bordspannungsnetz eines Fahrzeugs darstellt.

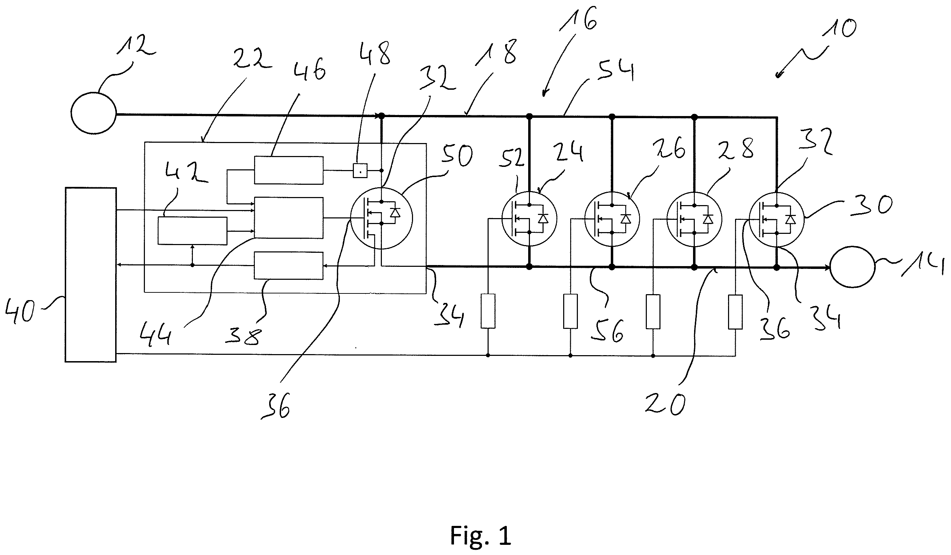

In Fig. 1 ist ein Teilbereich eines allgemein mit 10 bezeichneten Bordspannungsnetzes eines Fahrzeugs dargestellt. Der in Fig. 1 dargestellte Teil des Bordspannungsnetzes 10 zeigt eine Spannungsquelle 12, eine eine Mehrzahl von Verbrauchern elektrischer Energie umfassende Last 14 sowie eine die Spannungsquelle 12 mit der Last 14 wahlweise verbindende oder von dieser trennende Trennschalteranordnung 16. Die Trennschalteranordnung 16 umfasst einen an die Spannungsquelle 12, beispielsweise den Pluspol einer Batterie bzw. eines Akkumulators, angeschlossenen Spannungsquelle-Anschlussbereich 18 und einen an die Last 14 angeschlossenen Last-Anschlussbereich 20.

Die Trennschalteranordnung 16 umfasst ferner eine Mehrzahl von MOSFET-Trennschalterelementen 22, 24, 26, 28, 30. Jedes MOSFET-Trennschalterelement 22, 24, 26, 28, 30 umfasst einen Spannungsquelle-Anschluss 32, einen Last-Anschluss 34 und einen Gate-Anschluss 36. Bei Ausgestaltung der MOSFET-Trennschalterelemente 22, 24, 26, 38, 30 als n-Kanal-MOSFETs ist der Spannungsquelle-Anschlussbereich 32 im Wesentlichen durch den Drains-Anschluss bereitgestellt bzw. mit diesem verbunden, während der Last-Anschlussbereich 34 im Wesentlichen durch den Source-Anschluss bereitgestellt bzw. mit diesem verbunden ist.

Bei der in Fig. 1 dargestellten Trennschalteranordnung 16 ist das MOSFET-Trennschalterelement 22 als Stromüberwachung-Trennschalterelement ausgebildet, welches über eine Laststromerfassungsschaltung 38 eine den zwischen dem Spannungsquelle-Anschluss 32 und dem Last-Anschluss 34 desselben fließenden elektrischen Strom repräsentierende Stromgröße bereitstellt und diese Information beispielsweise zu einer Ansteuereinheit 40 leitet.

Das als Stromüberwachung-Trennschalterelement ausgebildete MOSFET-Trennschalterelement 22 umfasst ferner eine Überstrom-Schutzschaltung 42. Auch dieser wird die Stromgröße zugeführt, und beruhend auf der Stromgröße erkennt die Überstrom-Schutzschaltung 42, ob der zwischen dem Spannungsquelle-Anschluss 32 und dem Last-Anschluss 34 fließende elektrische Strom über oder unter einem maximal zulässigen Kurzschlussstrom liegt. Wird dieser erreicht bzw. überschritten, steuert die Überstrom-Schutzschaltung 42 eine Gate-Steuereinheit bzw. Ladungsträgerpumpe 44 des als Stromüberwachung-Trennschalterelement ausgebildeten MOSFET-Trennschalterelements 22 derart an, dass die leitende Verbindung zwischen dem Spannungsquelle-Anschluss 32 und dem Last-Anschluss 34 unterbrochen wird und das MOSFET-Trennschalterelement 22 in seinen die Spannungsquelle 12 von der Last 14 trennenden Zustand geschaltet wird.

Gleichermaßen umfasst das als Stromüberwachung-Trennschalterelement ausgebildete MOSFET-Trennschalterelement 22 eine Übertemperatur-Schutzschaltung 46. Dieser wird von einem Temperatursensor 48 Information über eine Temperatur im Bereich des als Stromüberwachung-Trennschalterelement ausgebildeten MOSFET-Trennschalterelements 22 zugeführt. Übersteigt diese Temperatur eine zulässige Schwellentemperatur, wird gleichermaßen die Gate-Ansteuereinheit 44 zum Unterbrechen der leitenden Verbindung zwischen dem Spannungsquelle-Anschluss 32, also dem Drain-Anschluss, und dem Last-Anschluss 34, also dem Source-Anschluss, angesteuert.

Um das als Stromüberwachung-Trennschalterelement ausgebildete MOSFET-Trennschalterelement 22 grundsätzlich zwischen einem leitenden Zustand, also dem Zustand, in welchem dieses die Spannungsquelle 12 mit der Last 14 verbindet, und seinem offenen Zustand, also dem Zustand, in welchem die Spannungsquelle 12 von der Last 14 getrennt ist, umschalten zu können, steht die Gate-Ansteuereinheit 44 in Ansteuerverbindung mit der Ansteuereinheit 40, welche abhängig von dem in einem Fahrzeug geforderten Betrieb der Last 14 bzw. der einzelnen Verbraucher elektrischer Energie derselben ein entsprechendes Ansteuersignal an die Gate-Ansteuereinheit 44 ausgibt, um bei Bedarf den leitenden Zustand des einen wesentlichen Bestandteil des MOSFET-Trennschalterelements 22 bereitstellenden MOSFET-Schalters 50 herzustellen.

Die weiteren MOSFET-Trennschalterelemente 24, 26, 28, 30 sind nicht als Stromüberwachung-Trennschalterelemente ausgebildet, sondern bilden mit ihren MOSFET-Schaltern 52 herkömmliche Lastschalter, welche durch entsprechende Ansteuerung der Gate-Anschlüsse 36 derselben in ihren leitenden, die Spannungsquelle 12 mit der Last 14 verbindenden Zustand geschaltet werden können. Wie in Fig. 1 veranschaulicht, stehen alle nicht als Stromüberwachung-Trennschalterelemente ausgebildeten MOSFET-Trennschalterelemente 24, 26, 28, 30 gemeinsam unter der Ansteuerung der Ansteuereinheit 40, so dass diese gemeinsam, also durch Ausgabe eines einzigen Ansteuersignals, zwischen ihrem leitenden und ihrem offenen Zustand umgeschaltet werden können.

Ein wesentlicher Unterschied zwischen dem als Stromüberwachung-Trennschalterelement ausgebildeten und allgemein als IPS (Intelligent Power Switch) bezeichneten MOSFET-Trennschalterelement 22 und den als Lastschalter wirkenden, nicht als Stromüberwachung-Trennschalterelemente ausgebildeten MOSFET-Trennschalterelementen 24, 26, 28, 30, ist, dass im leitenden Zustand das als Stromüberwachung-Trennschalterelement ausgebildete MOSFET-Trennschalterelement 22 vergleichsweise hochohmig ist und einen elektrischen Widerstand im mΩ-Bereich aufweist, während die nicht als Stromüberwachung-Trennschalterelemente ausgebildeten MOSFET-Trennschalterelemente 24, 26, 28, 30 im leitendem Zustand niederohmig sind und einen elektrischen Widerstand im µΩ-Bereich aufweisen. Ein weiterer wesentlicher Unterschied ist, dass der für das als Stromüberwachung-Trennschalterelement ausgebildete MOSFET-Trennschalterelement 22 maximal zulässige Strom im Bereich von maximal 100 bis 150 A liegt, während über die als Lastschalter wirkenden, nicht als Stromüberwachung-Trennschalterelemente ausgebildeten MOSFET-Trennschalterelemente 24, 26, 28, 30 jeweils ein Strom von mehreren 100 A geleitet werden kann.

Aufgrund der unterschiedlichen Widerstände im leitenden Zustand wird dann, wenn zwischen der Spannungsquelle 12 und der Last 14 ein Strom von mehreren 100 A, beispielsweise bis zu 600 A, fließen soll, ein Großteil des elektrischen Stroms über die zueinander parallel geschalteten, nicht als Stromüberwachung-Trennschalterelemente ausgebildeten MOSFET-Trennschalterelemente 24, 26, 28, 30 fließen, während über das als Stromüberwachung-Trennschalterelement ausgebildete MOSFET-Trennschalterelement 22, welches zu den nicht als Stromüberwachung-Trennschalterelementen ausgebildeten MOSFET-Trennschalterelementen 24, 26, 28, 30 parallel geschaltet ist, ein deutlich geringerer Strom fließen wird. Hierzu trägt bei, dass aufgrund der Parallelschaltung der niederohmigen, nicht als Stromüberwachung-Trennschalterelemente ausgebildeten MOSFET-Trennschalterelemente 24, 26, 28, 30 der durch diese bereitgestellte gesamte elektrische Widerstand bei 5 % bis 15 % des durch das als Stromüberwachung-Trennschalterelement bereitgestellten MOSFET-Trennschalterelements 22 liegt.

Da das Verhältnis der verschiedenen elektrischen Widerstände bekannt ist, kann durch das Bereitstellen der Stromgröße, welche grundsätzlich nur dem über das als Stromüberwachung-Trennschalterelement ausgebildete MOSFET-Trennschalterelement 22 fließenden elektrischen Strom entspricht, auf den über die gesamte Trennschalteranordnung 16 fließenden elektrischen Strom geschlossen werden, so dass unter Berücksichtigung der verschiedenen elektrischen Widerstände der verschiedenen MOSFET-Trennschalterelemente 22, 24, 26, 28, 30 und unter Berücksichtigung des Umstandes, dass an allen MOSFET-Trennschalterelementen 22, 24, 26, 28, 30 im Wesentlichen die gleiche elektrische Spannung anliegt, vermittels der Stromgröße auf den gesamten zwischen der Spannungsquelle 12 und der Last 14 fließenden elektrischen Strom geschlossen werden kann.

Da bei der Herstellung derartiger Halbleiterelemente Fertigungstoleranzen auch zu zumindest geringfügigen Abweichungen der elektrischen Widerstände führen können, ist es vorteilhaft, in einem Kalibriervorgang die elektrischen Widerstände der in der Trennschalteranordnung 16 eingesetzten MOSFET-Trennschalterelemente 22, 24, 26, 28, 30 bzw. der MOSFET-Schalter 50, 52 derselben zu ermitteln und dann unter Berücksichtigung der so ermittelten elektrischen Widerstände eine Berechnungsgrundlage bereitzustellen, vermittels welcher anhand der den elektrischen Strom über das MOSFET-Trennschalterelement 22 wiedergebenden Stromgröße der gesamte über die Trennschalteranordnung 16 fließende elektrischen Strom ermitteln werden kann.

Um für eine präzise Erfassung dieses elektrischen Stroms auch unter Berücksichtigung der einzelnen Widerstandswerte der verschiedenen in der Trennschalteranordnung 16 eingesetzten MOSFET-Trennschalterelemente 22, 24, 26, 28, 30 den über die Trennschalteranordnung 16 fließenden elektrischen Strom unter Berücksichtigung der Stromgröße exakt bestimmen zu können, ist es weiterhin vorteilhaft bzw. erforderlich, dafür zu sorgen, dass bei den verschiedenen MOSFET-Trennschalterelementen 22, 24, 26, 28, 30 näherungsweise gleiche Temperaturverhältnisse vorliegen und diese sich nicht unterschiedlich stark erwärmen und somit unterschiedliche Temperaturen aufweisen. Um dies zu erreichen, ist es vorteilhaft, alle MOSFET-Trennschalterelemente 22, 24, 26, 28, 30 beispielsweise mit ihrem jeweils einen Hauptanschluss bereitstellenden Drain-Anschlüssen, also den Spannungsquelle-Anschlüssen 32 derselben, auf einer beispielsweise mit Kupfermaterial aufgebauten und ein vergleichsweise massives Bauteil bereitstellenden Stromschiene 54 des Spannungsquelle-Anschlussbereichs 18 zu positionieren. Durch die Stromschiene 24 werden nicht nur die Spannungsquelle-Anschlüsse 32 der verschiedenen MOSFET-Trennschalterelemente 22, 24, 26, 28, 30 elektrisch leitend miteinander verbunden, sondern diese bzw. deren MOSFET-Schalter 50, 52 werden auch thermisch leitend miteinander verbunden. Somit kann ein Temperaturausgleich zwischen diesen stattfinden, und es ist gewährleistet, dass diese auf im Wesentlichen dem gleichen Temperaturniveau sind. Alternativ oder zusätzlich könnte der Last-Anschlussbereich 20 der Trennschalteranordnung 16 mit einer derartigen beispielsweise mit Kupfermaterial aufgebauten Stromschiene 56 ausgebildet sein.

Um bei der erfindungsgemäß aufgebauten Trennschalteranordnung 16 bzw. dem diese aufweisenden Bordspannungsnetz 10 dafür sorgen zu können, dass immer dann, wenn die Last 14 aus der Spannungsquelle 12 mit elektrischer Energie gespeist wird, Information über den zwischen der Spannungsquelle 12 und der Last fließenden elektrischen Strom zur Verfügung steht, wird immer dann, wenn die Trennschalteranordnung 16 in einen die Spannungsquelle 12 mit der Last 14 verbindenden Zustand zu schalten ist, zumindest das als Stromüberwachung-Trennschalterelement ausgebildete MOSFET-Trennschalterelement 22 in seinen leitenden, also die Spannungsquelle 12 mit der Last 14 verbindenden Zustand geschaltet.

Ist ein Fahrzeug bzw. das Bordspannungsnetz 10 in einem Niederlastzustand, in welchem aufgrund geringer Belastung bzw. Lastanforderung nur ein vergleichsweise niedriger Strom zu erwarten ist, beispielsweise in einem Parkzustand eines Fahrzeugs, kann es ausreichend sein, nur das als Stromüberwachung-Trennschalterelement ausgebildete MOSFET-Trennschalterelement 22 in seinen leitenden Zustand zu schalten, während die als Lastschalter wirkenden MOSFET-Trennschalterelemente 24, 26, 28, 30 mit ihrem offenen, die Spannungsquelle 12 von der Last 14 trennenden Zustand verbleiben bzw. geschaltet werden. Der gesamte zwischen der Spannungsquelle 12 und der Last 14 dann fließende elektrische Strom wird über das als Stromüberwachung-Trennschalterelement ausgebildete MOSFET-Trennschalterelement 22 geleitet, so dass in diesem Fall die Stromgröße tatsächlich auch den gesamten über die Trennschalteranordnung 16 fließenden elektrischen Strom repräsentiert. Somit ist gewährleistet, dass auch in einem derartigen Niederlastzustand aufgrund eines ausreichend großen elektrischen Stroms über das MOSFET-Trennschalterelement 22 eine präzise Stromerfassung erfolgen kann.

Nimmt, ausgehend von einem derartigen Niederlastzustand, beispielsweise aufgrund des Zuschaltens weiterer Verbraucher elektrischer Energie in der Last 14 der Stromfluss zu, kann dies zu einem Zustand führen, in welchem der zwischen der Spannungsquelle 12 und der Last 14 fließende elektrische Strom den für das als Stromüberwachung-Trennschalterelement ausgebildete MOSFET-Trennschalterelement 22 zulässigen maximalen Strom übersteigt. Dies kann beispielsweise dadurch erkannt werden, dass der zwischen der Spannungsquelle 12 und der Last 14 fließende elektrische Strom einen Schwellenstrom übersteigt oder dass der Stromgradient, also die zeitliche Änderung des elektrischen Stroms, derart groß ist, dass er einen zugeordneten Schwellenstromgradienten übersteigt. Unter Verwendung eines derartigen Schwellenstroms bzw. Schwellenstromgradienten kann also beispielsweise dann, wenn zumindest eine dieser Schwellen erreicht bzw. überschritten wird, der Zustand, in welchem der gesamte elektrische Strom über das als Stromüberwachung-Trennschalterelement ausgebildete MOSFET-Trennschalterelement 22 geleitet wird, beendet werden, indem die nicht als Stromüberwachung-Trennschalterelemente ausgebildeten MOSFET-Trennschalterelemente 24, 26, 28, 30 ebenfalls in ihren leitenden, die Spannungsquelle 12 mit der Last 14 verbindenden Zustand geschaltet werden. Eine Überlastung des als Stromüberwachung-Trennschalterelement ausgebildeten MOSFET-Trennschalterelements 22 kann somit vermieden werden.

Mit dem erfindungsgemäßen Aufbau einer Trennschalteranordnung bzw. eines diese aufweisenden Bordspannungsnetzes für ein Fahrzeug wird es möglich, unter Verwendung herkömmlicher MOSFET-Trennschalterelemente bzw. durch die Kombination zumindest eines als Stromüberwachung-Trennschalterelement ausgebildeten MOSFET-Trennschalterelements mit zumindest einem nicht als Stromüberwachung-Trennschalterelement ausgebildeten MOSFET-Trennschalterelements bei einem einfach strukturierten Aufbau zuverlässig Information über den zwischen einer Spannungsquelle und einer Last in einem Bordspannungsnetz fließenden elektrischen Strom bereitzustellen. Da abhängig von der Lastanforderung im Bordspannungssystem die verschiedenen MOSFET-Trennschalterelemente wahlweise leitend bzw. nicht leitend geschaltet werden können, wird es möglich, auch in einem Zustand, in welchem nur ein vergleichsweise geringer Strom zwischen einer Spannungsquelle und einer Last fließt, diesen zuverlässig und mit guter Dynamik erfassen zu können, gleichwohl jedoch eine Überlastung eines als Stromüberwachung-Trennschalterelement ausgebildeten MOSFET-Trennschalterelements zu vermeiden, auch wenn dieses aufgrund seiner baulichen Ausgestaltung nur einen vergleichsweise geringen Anteil des gesamten zwischen der Spannungsquelle und der Last fließenden elektrischen Stroms leiten kann. Somit kann bei hoher Messdynamik in einem großen Messbereich für den gesamt fließenden elektrischen Strom die Trennschalteranordnung mit geringer Verlustleistung und geringer Eigenstromaufnahme im Bereich von wenigen 100 µA betrieben werden. Da für den Aufbau der Trennschalteranordnung handelsübliche Halbleiterbauteile eingesetzt werden können, kann diese auch kostengünstig und grundsätzlich mit zuverlässig arbeitender Struktur bereitgestellt werden.

## Patentansprüche

1. Bordspannungsnetz für ein Fahrzeug, umfassend eine Spannungsquelle (12) und eine von der Spannungsquelle (12) mit elektrischer Energie zu speisende Last (14), ferner umfassend eine Trennschalteranordnung zum wahlweisen Verbinden der Spannungsquelle (12) mit der Last (14) und Trennen der Spannungsquelle (12) von der Last (14), die Trennschalteranordnung umfassend einen mit der Spannungsquelle (12) verbundenen Spannungsquelle-Anschlussbereich (18), einen mit der Last (14) verbundenen Last-Anschlussbereich (20) und eine Mehrzahl von zwischen dem Spannungsquelle-Anschlussbereich (18) und dem Last-Anschlussbereich (20) zueinander parallel geschalteten MOSFET-Trennschalterelementen (22, 24, 26, 28, 30), wobei wenigstens ein MOSFET-Trennschalterelement (22) der Mehrzahl von MOSFET-Trennschalterelementen (22, 24, 26, 28, 30) als Stromüberwachung-Trennschalterelement zum Bereitstellen einer einen zwischen dem Spannungsquelle-Anschlussbereich (18) und dem Last-Anschlussbereich (20) fließenden elektrischen Strom repräsentierenden Stromgröße ausgebildet ist und wenigstens ein MOSFET-Trennschalterelement (24, 26, 28, 30) der Mehrzahl von MOSFET-Trennschalterelementen (22, 24, 26, 28, 30) nicht als Stromüberwachung-Trennschalterelement ausgebildet ist, wobei:
- alle nicht als Stromüberwachung-Trennschalterelemente ausgebildeten MOSFET-Trennschalterelemente (24, 26, 28, 30) gemeinsam in einen Zustand zum Verbinden der Spannungsquelle (12) mit der Last (14) und einen Zustand zum Trennen der Spannungsquelle (12) von der Last (14) schaltbar sind und das wenigstens eine als Stromüberwachung-Trennschalterelement ausgebildete MOSFET-Trennschalterelement (22) unabhängig von jedem nicht als Stromüberwachung-Trennschalterelement ausgebildeten MOSFET-Trennschalterelement (24, 26, 28, 30) in einen Zustand zum Verbinden der Spannungsquelle mit der Last und einen Zustand zum Trennen der Spannungsquelle von der Last schaltbar ist,
- jedes MOSFET-Trennschalterelement (22, 24, 26, 28, 30) einen mit dem Spannungsquelle-Anschlussbereich (18) verbundenen Spannungsquelle-Anschluss (32), einen mit dem Last-Anschlussbereich (20) verbundenen Last-Anschluss (34) und einen mit einer Ansteuereinheit (40) verbundenen Gate-Anschluss (36) aufweist,
- das wenigstens eine als Stromüberwachung-Trennschalterelement ausgebildete MOSFET-Trennschalterelement (32) in seinem die Spannungsquelle (12) mit der Last (14) verbindenden leitenden Zustand einen Stromüberwachung-Trennschalterelement-Widerstand zwischen seinem Spannungsquelle-Anschluss (22) und seinem Last-Anschluss (34) aufweist, das wenigstens eine nicht als Stromüberwachung-Trennschalterelement ausgebildete MOSFET-Trennschalterelement (24, 26, 28, 30) in seinem die Spannungsquelle(12) mit der Last (14) verbindenden leitenden Zustand einen MOSFET-Trennschalterelement-Widerstand zwischen seinem Spannungsquelle-Anschluss (32) und seinem Last-Anschluss (34) aufweist, wobei der Stromüberwachung-Trennschalterelement-Widerstand größer ist als der MOSFET-Trennschalterelement-Widerstand.

2. Bordspannungsnetz nach Anspruch 1, **dadurch gekennzeichnet, dass** ein einziges MOSFET-Trennschalterelement (22) als Stromüberwachung-Trennschalterelement ausgebildet ist, oder/und dass eine Mehrzahl der MOSFET-Trennschalterelemente (24, 26, 28, 30) nicht als Stromüberwachung-Trennschalterelement ausgebildet ist.

3. Bordspannungsnetz nach Anspruch 1 oder 2, **dadurch gekennzeichnet, dass** der Spannungsquelle-Anschluss (32) ein Drain-Anschluss ist und der Last-Anschluss (34) ein Source-Anschluss ist.

4. Bordspannungsnetz nach Anspruch 1, 2 oder 3, **dadurch gekennzeichnet, dass** ein Verhältnis des durch alle nicht als Stromüberwachung-Trennschalterelement ausgebildeten MOSFET-Trennschalterelemente (24, 26, 28, 30) bereitgestellten Gesamt-MOSFET-Trennschalterelement-Widerstands zu dem durch alle als Stromüberwachung-Trennschalterelemente ausgebildeten MOSFET-Trennschalterelemente (22) bereitgestellten Gesamt-Stromüberwachung-Trennschalterelement-Widerstand im Bereich von 0,05-0,15 liegt.

5. Bordspannungsnetz nach einem der Ansprüche 1-4, **dadurch gekennzeichnet, dass** das wenigstens eine als Stromüberwachung-Trennschalterelement ausgebildete MOSFET-Trennschalterelement (22) eine Überstrom-Schutzschaltung (42) enthält, wobei die Überstrom-Schutzschaltung (42) dazu ausgebildet ist, bei über einem Schwellenstrom liegendem elektrischen Strom zwischen dem Spannungsquelle-Anschluss (32) und dem Last-Anschluss (34) des wenigstens einen als Stromüberwachung-Trennschalterelement ausgebildeten MOSFET-Trennschalterelements (22) das wenigstens eine als Stromüberwachung-Trennschalterelement ausgebildete MOSFET-Trennschalterelement (22) in einen Zustand zum Trennen der Spannungsquelle (12) von der Last (14) zu schalten oder in diesem zu halten.

6. Bordspannungsnetz nach einem der Ansprüche 1-5, **dadurch gekennzeichnet, dass** das wenigstens eine als Stromüberwachung-Trennschalterelement ausgebildete MOSFET-Trennschalterelement (22) eine Übertemperatur-Schutzschaltung (44) enthält, wobei die Übertemperatur-Schutzschaltung (44) dazu ausgebildet ist, bei über einer Schwellentemperatur liegender Temperatur des wenigstens einen als Stromüberwachung-Trennschalterelement ausgebildeten MOSFET-Trennschalterelements (22) das wenigstens eine als Stromüberwachung-Trennschalterelement ausgebildete MOSFET-Trennschalterelement (22) in einen Zustand zum Trennen der Spannungsquelle (12) von der Last (14) zu schalten oder in diesem zu halten.

7. Bordspannungsnetz nach einem der Ansprüche 1-6, **dadurch gekennzeichnet, dass** alle nicht als Stromüberwachung-Trennschalterelemente ausgebildeten MOSFET-Trennschalterelemente (24, 26, 28, 30) unter der Ansteuerung einer Ansteuereinheit (40) stehen, und dass alle nicht als Stromüberwachung-Trennschalterelemente ausgebildeten MOSFET-Trennschalterelemente (24, 26, 28, 30) durch ein einziges von der Ansteuereinheit (40) ausgegebenes Steuersignal gemeinsam zwischen dem Zustand zum Verbinden der Spannungsquelle (12) mit der Last (14) und dem Zustand zum Trennen der Spannungsquelle (12) von der Last (14) umschaltbar sind.

8. Bordspannungsnetz nach einem der Ansprüche 1-7, **dadurch gekennzeichnet, dass** der Spannungsquelle-Anschlussbereich (18) eine mit allen MOSFET-Trennschalterelementen (22, 24, 26, 28, 30) elektrisch und thermisch leitend verbundene Stromschiene (54), vorzugsweise Kupferschiene, umfasst, oder/und dass der Last-Anschlussbereich (20) eine mit allen MOSFET-Trennschalterelementen (22, 24, 26, 28, 30) elektrisch und thermisch leitend verbundene Stromschiene (56), vorzugsweise Kupferschiene, umfasst.

9. Verfahren zum Betreiben eines Bordspannungsnetzes nach einem der Ansprüche 1-8, bei welchem Verfahren in einem Niederlast-Betriebszustand des Bordspannungsnetzes (10) wenigstens ein als Stromüberwachung-Trennschalterelement ausgebildetes MOSFET-Trennschalterelement (22) in einen Zustand zum Verbinden der Spannungsquelle (12) mit der Last (14) geschaltet ist und wenigstens ein nicht als Stromüberwachung-Trennschalterelement ausgebildetes MOSFET-Trennschalterelement (24, 26, 28, 30) in einen Zustand zum Trennen der Spannungsquelle (12) von der Last (14) geschaltet ist.

10. Verfahren nach Anspruch 9, **dadurch gekennzeichnet, dass** in dem Niederlast-Betriebszustand jedes als Stromüberwachung-Trennschalterelement ausgebildete MOSFET-Trennschalterelement (22) in den Zustand zum Verbinden der Spannungsquelle (12) mit der Last (14) geschaltet ist oder/und jedes nicht als Stromüberwachung-Trennschalterelement ausgebildete MOSFET-Trennschalterelement (24, 26, 28, 30) in den Zustand zum Trennen der Spannungsquelle (12) von der Last (14) geschaltet ist.

11. Verfahren nach Anspruch 9 oder 10, **dadurch gekennzeichnet, dass** dann, wenn in dem Niederlast-Betriebszustand alle nicht als Stromüberwachung-Trennschalterelemente ausgebildeten MOSFET-Trennschalterelemente (24, 26, 28, 30) in den Zustand zum Trennen der Spannungsquelle (12) von der Last (14) geschaltet sind, wenigstens ein Teil der, vorzugsweise alle nicht als Stromüberwachung-Trennschalterelemente ausgebildeten MOSFET-Trennschalterelemente (24, 26, 28, 30) in den Zustand zum Verbinden der Spannungsquelle (12) mit der Last (14) geschaltet werden, wenn die durch das wenigstens eine als Stromüberwachung-Trennschalterelement ausgebildete MOSFET-Trennschalterelement (22) bereitgestellte Stromgröße einen über einem Schwellenstrom liegenden elektrischen Strom indiziert oder/und eine über einem Schwellenstromgradienten liegende zeitliche Änderung des elektrischen Stroms indiziert.

12. Verfahren nach einem der Ansprüche 9-11, **dadurch gekennzeichnet, dass** dann, wenn die Spannungsquelle (12) vermittels der Trennschalteranordnung (16) mit der Last (14) zu verbinden ist, wenigstens das wenigstens eine als Stromüberwachung-Trennschalterelement ausgebildete MOSFET-Trennschalterelement (22) in einen Zustand zum Verbinden der Spannungsquelle (12) mit der Last (14) geschaltet wird.

## Claims

1. An on-board voltage network for a vehicle, comprising a voltage source (12) and a load (14) to be supplied with electric energy by the voltage source (12), further comprising a disconnector assembly for the optional connection of a voltage source (12) to the load (14) and the isolation of the voltage source (12) from the load (14), the disconnector assembly comprising a voltage source terminal region (18) connected to the voltage source, and a load terminal region (20) connected to the load (14), and a plurality of MOSFET disconnecting switch elements (22, 24, 26, 28, 30) which are mutually connected in parallel between the voltage source terminal region (18) and the load terminal region (20), wherein at least one MOSFET disconnecting switch element (22) of the plurality of MOSFET disconnecting switch elements (22, 24, 26, 28, 30) is configured as a current monitoring disconnecting switch element for the delivery of a representative current variable for a current flowing between the voltage source terminal region (18) and the load terminal region (20), and at least one MOSFET disconnecting switch element (24, 26, 28, 30) of the plurality of MOSFET disconnecting switch elements (22, 24, 26, 28, 30) is not configured as a current monitoring disconnecting switch element, wherein:
- all the MOSFET disconnecting switch elements (24, 26, 28, 30) which are not configured as current monitoring disconnecting switch elements are commonly switchable to a state for connecting the voltage source (12) to the load (14) and to a state for isolating the voltage source (12) from the load (14) and the at least one MOSFET disconnecting switch element (22) which is configured as a current monitoring disconnecting switch element, independently of each MOSFET disconnecting switch element (24, 26, 28, 30) which is not configured as a current monitoring disconnecting switch element, is switchable to a state for connecting the voltage source to the load, and to a state for isolating the voltage source from the load,
- each MOSFET disconnecting switch element (22, 24, 26, 28, 30) comprises a voltage source terminal (32) which is connected to the voltage source terminal region (18), a load terminal (34) which is connected to the load terminal region (20), and a gate terminal (36) which is connected to a control unit (40),
- the at least one MOSFET disconnecting switch element (32) which is configured as a current monitoring disconnecting switch element, in its conducting state, wherein the voltage source (12) is connected to the load (14) comprises a current monitoring disconnecting switch element resistance between its voltage source terminal (22) and its load terminal (34), the at least one MOSFET disconnecting switch element (24, 26, 28, 30) which is not configured as a current monitoring disconnecting switch element, in its conducting state, wherein the voltage source (12) is connected to the load (14), comprises a MOSFET disconnecting switch element resistance between its voltage source terminal (32) and its load terminal (34), wherein the current monitoring disconnecting switch element resistance is greater than the MOSFET disconnecting switch element resistance.

2. The on-board voltage network as claimed in claim 1, **characterized in that** a single MOSFET disconnecting switch element (22) is configured as a current monitoring disconnecting switch element and/or **in that** a plurality of MOSFET disconnecting switch elements (24, 26, 28, 30) are not configured as current monitoring disconnecting switch elements.

3. The on-board voltage network as claimed in claim 1 or 2, **characterized in that** the voltage source terminal (32) is a drain terminal and the load terminal (34) is a source terminal.

4. The on-board voltage network as claimed in claims 1, 2 or 3, **characterized in that** a ratio of the total MOSFET disconnecting switch element resistance of all the MOSFET disconnecting switch elements (24, 26, 28, 30) which are not configured as current monitoring disconnecting switch elements to the total current monitoring disconnecting switch element resistance of all the MOSFET disconnecting switch elements (22) which are configured as current monitoring disconnecting switch elements lies within a range of 0.05-0.15.

5. The on-board voltage network as claimed in one of claims 1 to 4, **characterized in that** the at least one MOSFET disconnecting switch element (22) which is configured as a current monitoring disconnecting switch element incorporates an overcurrent protection circuit (42), wherein the overcurrent protection circuit (42) is designed, in the event of an electric current between the voltage source terminal (32) and the load terminal (34) of the at least one MOSFET disconnecting switch element (22) which is configured as a current monitoring disconnecting switch element, to switch the at least one MOSFET disconnecting switch element (22) which is configured as a current monitoring disconnecting switch element to a state wherein the voltage source (12) is isolated from the load (14), or to execute the maintenance thereof in this state.

6. The on-board voltage network as claimed in one of claims 1 to 5, **characterized in that** the at least one MOSFET disconnecting switch element (22) which is configured as a current monitoring disconnecting switch element incorporates an overtemperature protection circuit (44), wherein the overtemperature protection circuit (44) is configured, in the event of a temperature on the at least one MOSFET disconnecting switch element (22) which is configured as a current monitoring disconnecting switch element which exceeds a threshold temperature, to switch the at least one MOSFET disconnecting switch element (22) which is configured as a current monitoring disconnecting switch element to a state wherein the voltage source (12) is isolated from the load (14), or to execute the maintenance thereof in this state.

7. The on-board voltage network as claimed in one of claims 1 to 6, **characterized in that** all the MOSFET disconnecting switch elements (24, 26, 28, 30) which are not configured as current monitoring disconnecting switch elements are controlled by a control unit (40) and **in that** all the MOSFET disconnecting switch elements (24, 26, 28, 30) which are not configured as current monitoring disconnecting switch elements are commonly switchable between a state for connecting the voltage source (12) to the load (14) and a state for isolating the voltage source (12) from the load (14) by a single control signal emitted by the control unit (40).

8. The on-board voltage network as claimed in one of claims 1 to 7, **characterized in that** the voltage source terminal region (18) comprises a conductor rail (54) which is connected to all the MOSFET disconnecting switch elements (22, 24, 26, 28, 30) in an electrically and thermally conductive manner, preferably a copper rail, and/or **in that** the load terminal region (20) comprises a conductor rail (56) which is connected to all the MOSFET disconnecting switch elements (22, 24, 26, 28, 30) in an electrically and thermally conductive manner, preferably a copper rail.

9. A method for operating an on-board voltage network as claimed in one of claims 1 to 8, in which method, in a low-load operating state of the on-board voltage network (10), at least one MOSFET disconnecting switch element (22) which is configured as a current monitoring disconnecting switch element is switched to a state for connecting the voltage source (12) to the load (14), and at least one MOSFET disconnecting switch element (24, 26, 28, 30) which is not configured as a current monitoring disconnecting switch element is switched to a state for isolating the voltage source (12) from the load (14). .

10. The method as claimed in claim 9, **characterized in that**, in the low-load operating state, each MOSFET disconnecting switch element (22) which is configured as a current monitoring switch element is switched to a state for connecting the voltage source (12) to the load (14) and/or each MOSFET disconnecting switch element (24, 26, 28, 30) which is not configured as a current monitoring disconnecting switch element is switched to a state for isolating the voltage source (12) from the load (14).

11. The method as claimed in claim 9 or 10, **characterized in that**, in the event that, in a low-load operating state, all MOSFET disconnecting switch elements (24, 26, 28, 30) which are not configured as current monitoring disconnecting switch elements are switched to a state for isolating the voltage source (12) from the load (14), at least a part of, and preferably all the MOSFET disconnecting switch elements which are not configured as current monitoring disconnecting switch elements (24, 26, 28, 30) should be switched to a state for connecting the voltage source (12) to the load (14), in the event that the magnitude of current delivered by the at least one MOSFET disconnecting switch element (22) which is configured as a current monitoring disconnecting switch element indicates an electric current which exceeds a current threshold and/or indicates a temporal variation in the electric current which exceeds a threshold current gradient.

12. The method as claimed in one of claims 9 to 11, **characterized in that**, if the voltage source (12) is to be connected to the load (14) via the disconnector assembly (16), at least the at least one MOSFET disconnecting switch element (22) which is configured as a current monitoring disconnecting switch element is switched to a state for connecting the voltage source (12) to the load (14).

## Revendications

1. Un réseau de tension embarqué pour un véhicule, comprenant une source de tension (12) et une charge (14) à alimenter en énergie électrique par la source de tension (12), comprenant en outre un ensemble de déconnexion pour la connexion optionnelle d'une source de tension (12) à la charge (14) et l'isolation de la source de tension (12) de la charge (14), l'ensemble de déconnexion comprenant une région de borne de source de tension (18) connectée à la source de tension, et une région de borne de charge (20) connectée à la charge (14), et une pluralité d'éléments de commutation de déconnexion MOSFET (22, 24, 26, 28, 30) qui sont mutuellement connectés en parallèle entre la région de borne de source de tension (18) et la région de borne de charge (20), dans lequel au moins un élément de commutation de déconnexion MOSFET (22) de la pluralité d'éléments de commutation de déconnexion MOSFET (22, 24, 26, 28, 30) est configuré comme un élément de commutation de déconnexion de surveillance de courant pour la fourniture d'une variable de courant représentative d'un courant circulant entre la région de borne de source de tension (18) et la région de borne de charge (20), et au moins un élément de commutation de déconnexion MOSFET (24, 26, 28, 30) parmi la pluralité d'éléments de commutation de déconnexion MOSFET (22, 24, 26, 28, 30) n'est pas configuré comme un élément de commutation de déconnexion de surveillance de courant, dans lequel :
- tous les éléments de commutation de déconnexion MOSFET (24, 26, 28, 30) qui ne sont pas configurés comme des éléments de commutation de déconnexion de surveillance de courant peuvent être commutés de manière commune vers un état permettant de connecter la source de tension (12) à la charge (14) et vers un état permettant d'isoler la source de tension (12) de la charge (14) et ledit au moins un élément de commutation de déconnexion MOSFET (22) qui est configuré comme un élément de commutation de déconnexion de surveillance de courant, indépendamment de chaque élément de commutation de déconnexion MOSFET (24, 26, 28, 30) qui n'est pas configuré comme un élément de commutation de déconnexion de surveillance de courant, peut être commuté dans un état permettant de connecter la source de tension à la charge et dans un état permettant d'isoler la source de tension de la charge,
- chaque élément de commutation de déconnexion MOSFET (22, 24, 26, 28, 30) comprend une borne de source de tension (32) qui est connectée à la région de borne de source de tension (18), une borne de charge (34) qui est connectée à la région de borne de charge (20), et une borne de grille (36) qui est connectée à une unité de commande (40),
- ledit au moins un élément de commutation de déconnexion MOSFET (32) qui est configuré comme un élément de commutation de déconnexion de surveillance de courant, dans son état conducteur, dans lequel la source de tension (12) est connectée à la charge (14), comprend une résistance d'élément de commutation de déconnexion de surveillance de tension entre sa borne de source de tension (22) et sa borne de charge (34), ledit au moins un élément de commutation de déconnexion MOSFET (24, 26, 28, 30) qui n'est pas configuré comme un élément de commutation de déconnexion de surveillance de courant, dans son état conducteur, dans lequel la source de tension (12) est connectée à la charge (14), comprend une résistance d'élément de commutation de déconnexion MOSFET entre sa borne de source de tension (32) et sa borne de charge (34), dans lequel la résistance d'élément de commutation de déconnexion de surveillance de courant est supérieure à la résistance d'élément de commutation de déconnexion MOSFET.

2. Le réseau de tension embarqué selon la revendication 1, **caractérisé en ce qu'**un seul élément de commutation de déconnexion MOSFET (22) est configuré comme élément de commutation de déconnexion de surveillance de courant et/ou **en ce qu'**une pluralité d'éléments de commutation de déconnexion MOSFET (24, 26, 28, 30) ne sont pas configurés comme éléments de commutation de déconnexion de surveillance de courant.

3. Le réseau de tension embarqué selon la revendication 1 ou 2, **caractérisé en ce que** la borne de source de tension (32) est une borne de drain et la borne de charge (34) est une borne de source.

4. Le réseau de tension embarqué selon les revendications 1, 2 ou 3, **caractérisé en ce qu'**un rapport entre la résistance totale des éléments de commutation de déconnexion MOSFET de tous les éléments de commutation de déconnexion MOSFET (24, 26, 28, 30) qui ne sont pas configurés comme des éléments de commutation de déconnexion de surveillance de courant est compris dans une plage de 0,05 à 0,15 par rapport à la résistance totale des éléments de commutation de déconnexion de surveillance de tension de tous les éléments de commutation de déconnexion MOSFET (22) qui sont configurés comme des éléments de commutation de déconnexion de surveillance de courant.

5. Le réseau de tension embarqué selon l'une des revendications 1 à 4, **caractérisé en ce que** ledit au moins un élément de commutation de déconnexion MOSFET (22) qui est configuré comme un élément de commutation de déconnexion de surveillance de courant comprend un circuit de protection contre les surintensités (42), dans lequel le circuit de protection contre les surintensités (42) est conçu, en cas de courant électrique entre la borne de source de tension (32) et la borne de charge (34) dudit au moins un élément de commutation de déconnexion MOSFET (22) qui est configuré comme un élément de commutation de déconnexion de surveillance de courant, pour commuter ledit au moins un élément de commutation de déconnexion MOSFET (22) qui est configuré comme un élément de commutation de déconnexion de surveillance de courant dans un état dans lequel la source de tension (12) est isolée de la charge (14), ou pour exécuter la maintenance de celui-ci dans cet état.

6. Le réseau de tension embarqué selon l'une des revendications 1 à 5, **caractérisé en ce que** ledit au moins un élément de commutation de déconnexion MOSFET (22) configuré comme un élément de commutation de déconnexion de surveillance de courant comprend un circuit de protection contre la surchauffe (44), dans lequel le circuit de protection contre la surchauffe (44) est configuré en cas de température sur ledit au moins un élément de commutation de déconnexion MOSFET (22) qui est configuré comme un élément de commutation de déconnexion de surveillance de courant qui dépasse une température seuil, pour commuter ledit au moins un élément de commutation de déconnexion MOSFET (22) qui est configuré comme un élément de commutation de déconnexion de surveillance de courant dans un état dans lequel la source de tension (12) est isolée de la charge (14), ou pour exécuter la maintenance de celle-ci dans cet état.

7. Le réseau de tension embarqué selon l'une des revendications 1 à 6, **caractérisé en ce que** tous les éléments de commutation de déconnexion MOSFET (24, 26, 28, 30) qui ne sont pas configurés comme des éléments de commutation de déconnexion de surveillance de courant sont commandés par une unité de commande (40) et **en ce que** tous les éléments de commutation de déconnexion MOSFET (24, 26, 28, 30) qui ne sont pas configurés comme des éléments de commutation de déconnexion de surveillance de courant peuvent être commutés de manière commune entre un état pour connecter la source de tension (12) à la charge (14) et un état pour isoler la source de tension (12) de la charge (14) par un seul signal de commande émis par l'unité de commande (40).

8. Le réseau de tension embarqué selon l'une des revendications 1 à 7, **caractérisé en ce que** la région de borne de source de tension (18) comprend un rail conducteur (54) qui est connecté à tous les éléments de commutation de déconnexion MOSFET (22, 24, 26, 28, 30) de manière électriquement et thermiquement conductrice, de préférence un rail en cuivre, et/ou **en ce que** la région de borne de charge (20) comprend un rail conducteur (56) qui est connecté à tous les éléments de commutation de déconnexion MOSFET (22, 24, 26, 28, 30) de manière électriquement et thermiquement conductrice, de préférence un rail en cuivre.

9. Un procédé pour faire fonctionner un réseau de tension embarqué selon l'une des revendications 1 à 8, dans lequel, dans un état de fonctionnement à faible charge du réseau de tension embarqué (10), au moins un élément de commutation de déconnexion MOSFET (22) qui est configuré comme un élément de commutation de déconnexion de surveillance de courant est commuté dans un état permettant de connecter la source de tension (12) à la charge (14), et au moins un élément de commutation de déconnexion MOSFET (24, 26, 28, 30) qui n'est pas configuré comme un élément de commutation de déconnexion de surveillance de courant est commuté dans un état permettant d'isoler la source de tension (12) de la charge (14).

10. Le procédé selon la revendication 9, **caractérisé en ce que**, dans l'état de fonctionnement à faible charge, chaque élément de commutation de déconnexion MOSFET (22) qui est configuré comme un élément de commutation de surveillance de courant est commuté dans un état permettant de connecter la source de tension (12) à la charge (14) et/ou chaque élément de commutation de déconnexion MOSFET (24, 26, 28, 30) qui n'est pas configuré comme un élément de commutation de déconnexion de surveillance de courant est commuté dans un état permettant d'isoler la source de tension (12) de la charge (14).

11. Le procédé selon la revendication 9 ou 10, **caractérisé en ce que**, dans le cas où, dans un état de fonctionnement à faible charge, tous les éléments de commutation de déconnexion MOSFET (24, 26, 28, 30) qui ne sont pas configurés comme des éléments de commutation de déconnexion de surveillance de courant sont commutés dans un état permettant d'isoler la source de tension (12) de la charge (14), au moins une partie, et de préférence la totalité, des éléments de commutation de déconnexion MOSFET qui ne sont pas configurés comme des éléments de commutation de déconnexion de surveillance de courant (24, 26, 28, 30) doivent être commutés dans un état permettant de connecter la source de tension (12) à la charge (14), dans le cas où l'amplitude de courant fourni par ledit au moins un élément de commutation de déconnexion MOSFET (22) qui est configuré comme un élément de commutation de déconnexion de surveillance de courant indique un courant électrique qui dépasse un seuil de courant et/ou indique une variation temporelle de courant électrique qui dépasse un gradient de courant seuil.

12. Le procédé selon l'une des revendications 9 à 11, **caractérisé en ce que**, si la source de tension (12) doit être connectée à la charge (14) via l'ensemble de commutation de déconnexion (16), au moins ledit au moins un élément de commutation de déconnexion MOSFET (22) qui est configuré comme un élément de commutation de déconnexion de surveillance de courant est commuté dans un état permettant de connecter la source de tension (12) à la charge (14).
